Europäisches Patentamt

European Patent Office

Office européen des brevets

(19)

(11) **EP 1 274 289 A1**

(12) **EUROPÄISCHE PATENTANMELDUNG**

(43) Veröffentlichungstag:
   **08.01.2003 Patentblatt 2003/02**

(51) Int Cl.$^7$: **H05K 3/46**, H05K 3/00

(21) Anmeldenummer: **01440200.2**

(22) Anmeldetag: **02.07.2001**

(84) Benannte Vertragsstaaten:
   **AT BE CH CY DE DK ES FI FR GB GR IE IT LI LU MC NL PT SE TR**
   Benannte Erstreckungsstaaten:
   **AL LT LV MK RO SI**

(71) Anmelder: **ALCATEL**
   **75008 Paris (FR)**

(72) Erfinder: **Hoffmann, Hans**
   **74348 Lauffen (DE)**

(74) Vertreter: **KOHLER SCHMID + PARTNER**
   **Patentanwälte**
   **Ruppmannstrasse 27**
   **70565 Stuttgart (DE)**

(54) **HDI Leiterplatte und Herstellungsverfahren einer HDI Leiterplatte**

(57)   Bei einem Verfahren zur Herstellung von mehrlagigen High Density Interconnect (HDI) Leiterplatten (1) werden Orientierungspunkte (3-6) für die einzelnen Lagen auf einem Montagerahmen (2) außerhalb der eigentlichen Leiterplatte (1) angeordnet und wird ein weiterer Orientierungspunkt (10) als Ursprung für alle Lagen auf der eigentlichen Leiterplatte (1) angeordnet. Somit können geringere Toleranzen bei der Herstellung realisiert werden.

# Fig. 1

EP 1 274 289 A1

**Beschreibung**

Die Erfindung betrifft ein Verfahren zur Herstellung von mehrlagigen High Density Interconnect (HDI) Leiterplatten, bei dem Orientierungspunkte für die einzelnen Lagen auf einem Montagerahmen außerhalb der eigentlichen Leiterplatte angeordnet werden.

Unter High Density Interconnect (HDI) - Leiterplatten versteht man mehrlagige Leiterplatten mit einer mittleren Kontaktdichte von mehr als 20 Pads/cm$^2$, mit Array-Rastermasken von weniger als 1,0 mm und mit Microvias. Pads sind Anschlussflächen auf der Leiterplatte für elektronische Bauelemente. Hier wird der Kontakt zwischen Bauelementanschluss und den elektrischen Verbindungen auf der Leiterplatte hergestellt. Ein Microvia ist im Wesentlichen ein Verbindungsloch zwischen den funktionellen Lagen. Insbesondere werden als Microvias Through-Vias, Buried-Vias oder Blind-Vias bezeichnet, deren Durchmesser kleiner als 150μm ist, unabhängig von der Herstellungsweise. Microvias können mit elektrisch leitfähigem Material gefüllt werden, um eine elektrische Verbindung zwischen den Lagen herzustellen.

Bei der Herstellung von HDI-Leiterplatten werden Folien in typischerweise bis zu 20 Lagen verwendet. Es können jedoch auch mehr als 20 Lagen verwendet werden. Diese Folien und darauf z.B. durch Lithographie definierte und beispielsweise durch Ätzprozesse erzeugte Strukturen werden zueinander ausgerichtet. Unter Strukturen sind die aus einer vollständigen Kupferfläche geätzten oder gefrästen elektrischen Verbindungen zu verstehen. Die Strukturen können jedoch auch durch Bedrucken erzeugt werden. Die Lagen werden in einem oder mehreren Pressschritten miteinander verpresst. Insbesondere müssen auch die Microvias richtig ausgerichtet werden, so dass die verschiedenen Lagen an den richtigen Stellen miteinander leitend verbunden sind.

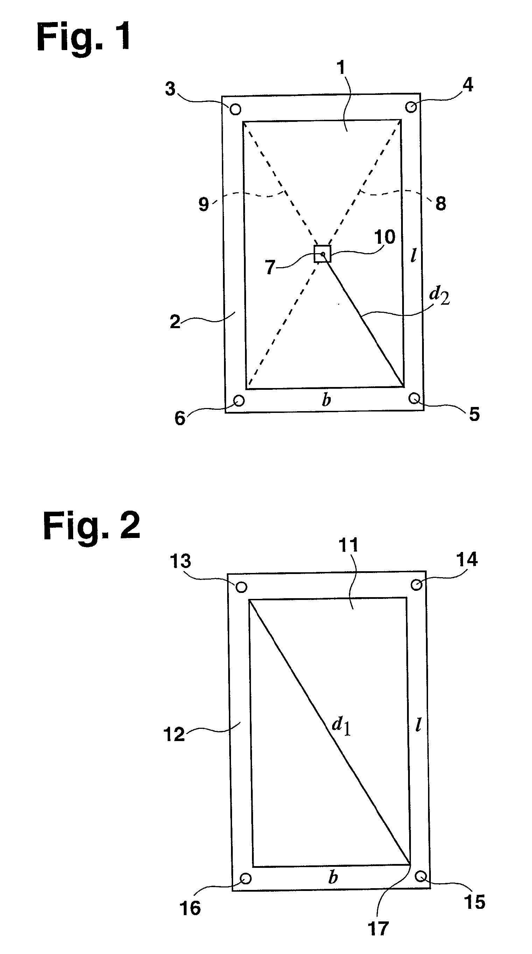

In der **Fig. 2** ist eine standardmäßige HDI-Leiterplatte (HDI printed board) **11** dargestellt. Die eigentliche Leiterplatte 11 ist von einem Montagerahmen **12** umgeben, der nach Fertigstellung der Leiterplatte entfernt werden kann. Die Leiterplatte 11 und der Montagerahmen 12 sind einstückig ausgebildet, d.h. der Montagerahmen ist ein nicht mit Strukturen versehener Randbereich der gesamten Leiterplatte bzw. der einzelnen Folien. Auf dem Montagerahmen 12 sind Orientierungspunkte (registration marks) **13 - 16** angebracht. An den Orientierungspunkten 13 - 16 werden die Folien der verschiedene Lagen ausgerichtet. Der Orientierungspunkt 13 dient als Ursprung (Null-Punkt) für die Ausrichtung von beispielsweise Bohr-, Ätz- und Belichtungsmaschinen, die bei der Herstellung der Leiterplatte 1 verwendet werden, um die Strukturen auf der Leiterplatte 11 zu erzeugen. Bei der Herstellung der Leiterplatten 11 muss Ausdehnungsunterschieden der verschiedenen Lagen Rechnung getragen werden, die insbesondere beim Verpressen der Lagen auftreten. Die Ausdehnungsunterschiede rühren von unterschiedlichen verwendeten Materialien für die einzelnen Lagen und von unterschiedlichen Lagendicken her. Diese Ausdehnungsunterschiede können schon bei der Herstellung insofern berücksichtigt werden, als bei der Definition von Strukturen auf den einzelnen Lagen die Ausdehnung der Lage berücksichtigt wird, so dass sich die Strukturen bei fertig gestellter Leiterplatte, d.h. nach einem oder mehreren Verpressvorgängen, in der richtigen Position befinden. Es kommt also darauf an, die Lagen und Strukturen möglichst genau, d.h. mit geringer Toleranz auszurichten. Bei kleineren Leiterplatten, z.B. 233 mm x 160 mm oder 233 mm x 210 mm konnten mit den Orientierungspunkten 3 bis 6 hinreichend gute Toleranzen erzielt werden. Bei großen HDI Leiterplatten, z.B. mit den Maßen 500 mm x 310 mm, können mit diesen Orientierungspunkten jedoch keine hinreichend guten Toleranzen erzielt werden, da der am weitesten vom Ursprung 13 entfernte Punkt **17** der Leiterplatte 11 etwa $d_1 = \sqrt{1^2 + b^2}$ von dem Ursprung 13 entfernt ist und ein solcher Punkt unter Berücksichtigung der Ausdehnung der Lagen nicht hinreichend genau von einer Maschine angefahren werden kann.

Aufgabe der vorliegenden Erfindung ist es daher, ein Verfahren zur Herstellung von HDI-Leiterplatten mit geringerer Toleranz bereit zu stellen.

Gelöst wird diese Aufgabe erfindungsgemäß durch ein Verfahren der eingangs genannten Art, bei dem ein weiterer Orientierungspunkt als Ursprung für alle Lagen auf der eigentlichen Leiterplatte angeordnet wird.

Durch die Definition eines neuen Ursprungs auf der Leiterplatte können Fertigungsmaschinen wie Bohr- oder Fräsmaschinen an diesem Ursprung ausgerichtet werden. Der maximale Weg, den ein Werkzeug zurücklegen muss, wird durch diese Maßnahme reduziert. Somit können geringere Toleranzen realisiert werden.

Bei einer vorteilhaften Verfahrensvariante wird der weitere Orientierungspunkt im Zentrum der eigentlichen Leiterplatte gewählt. Wird der weitere Orientierungspunkt, d.h. der Ursprung im Zentrum der Leiterplatte, insbesondere auf dem Schnittpunkt der Diagonalen der Leiterplatte, vorgesehen, beträgt der maximal von einem Werkzeug in eine Richtung zurück zu legende Weg $d_2 = \frac{1}{2}\sqrt{1^2 + b^2}$ und somit die Hälfte des maximal zurückzulegenden Wegs bei Herstellungsverfahren gemäß dem Stand der Technik. Auch die Berechnung der Skalierung von Strukturen bzw. der Platzierung von Strukturen für Lagen mit unterschiedlicher Ausdehnung kann von diesem Punkt aus erfolgen. Ausgehend von diesem Punkt kann eine genauere Berechnung mit kleinerer Toleranzen erfolgen.

Wenn alle Herstellungsschritte an dem weiteren Orientierungspunkt ausgerichtet werden, können die einzelnen Lagen mit wesentlich geringerer Toleranz einander überlagert werden.

In einem weiteren Aspekt der Erfindung wird die Aufgabe durch eine HDI Leiterplatte gelöst, bei der mindestens ein Orientierungspunkt für die Ausrichtung der Lagen und/oder Strukturen während der Herstellung der Leiterplatte auf der Leiterplatte vorgesehen ist. Der Orientierungspunkt kann vor Beginn der Fertigung auf einer Trägerplatte definiert werden und/oder aber auf jeder Lage der HDI-Leiterplatte definiert sein.

Bei einer bevorzugten Ausgestaltung der Erfindung ist der Orientierungspunkt im Zentrum der Leiterplatte angeordnet. Somit lässt sich eine HDI-Leiterplatte mit besonders geringer Toleranz herstellen.

Ist die HDI Leiterplatte von einem Montagerahmen umgeben, der weitere Orientierungspunkte aufweist, kann die Ausrichtung an dem Orientierungspunkt auf der Leiterplatte überprüft werden. Außerdem können nicht kritische Lagen, d.h. Lagen deren Ausrichtung mit größerer Toleranz durchgeführt werden kann, auf herkömmliche Art und Weise an den Orientierungspunkten des Montagerahmens ausgerichtet werden.

Ein weiterer Aspekt der Erfindung betrifft eine Montagevorrichtung zur Herstellung einer HDI-Leiterplatte unter Verwendung eines Orientierungspunktes auf der Leiterplatte.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigte und beschriebene Ausführungsform ist nicht als abschließende Aufzählung zu verstehen, sondern hat vielmehr beispielhaften Charakter für die Schilderung der Erfindung.

Die Erfindung ist in der Zeichnung dargestellt und wird anhand eines Ausführungsbeispiels naher erläutert. Es zeigt:

**Fig. 1**   eine erfindungsgemäße HDI Leiterplatte mit einem Orientierungspunkt;

**Fig. 2**   eine HDI Leiterplatte des Standes der Technik.

In der **Fig. 1** ist eine HDI-Leiterplatte **1** dargestellt. Die eigentliche Leiterplatte 1 ist von einem Montagerahmen **2** umgeben, der nach Fertigstellung der Leiterplatte entfernt wird. Auf dem Montagerahmen 2 sind Orientierungspunkte **3 bis 6** angebracht. Sie befinden sich im Beispiel im Bereich der Ecken des rechtekkigen Montagerahmens 2. An den Orientierungspunkten 3 bis 6 können die Folien der verschiedene Lagen ausgerichtet werden, deren Ausrichtung mit großer Toleranz erfolgen kann. Auf dem Kreuzungspunkt **7** der Diagonalen **8, 9** der Leiterplatte 1 liegt ein weiterer Orientierungspunkt **10**, der als Ursprung für die Registrierung (passgenaue Anordnung) der Lagen, die mit geringer Toleranz ausgerichtet werden müssen, und für Herstellungswerkzeuge dient. Im Ausführungsbeispiel ist der optisch automatisch erkennbare Orientierungspunkt 10 als Kreis, der von einem quadratischen Rahmen umgeben ist, ausgebildet, wobei der Kreis auf dem Kreuzungspunkt 7 liegt. Der maximale Weg, der von einem Herstellungswerkzeug, das den Orientierungspunkt 10 als Ursprung nutzt, zu durchlaufen ist, ist $d_2 = \frac{1}{2}\sqrt{1^2+b^2}$.

Das Herstellungsverfahren einer HDI Leiterplatte soll anhand eines Beispiels erläutert werden. Zunächst wird ein Leiterplattenkern aus Rohmaterial, wie z.B. Kupfer und Epoxyharz-Glasgewebe (Dielektrikum), hergestellt, wobei je nach Aufbau der Leiterplatte eine oder beide äußere Schichten des Leiterplattenkerns eine Kupferschicht ist. Eine Registriermarke (Orientierungspunkt als Ursprung) wird im Zentrum des Leiterplattenkerns angebracht, indem entweder ein Loch, z. B. durch Bohren oder Stanzen, oder eine Struktur, z.B. durch Ätzen, Fräsen oder Bearbeitung mit Laserlicht, erzeugt wird. Eine die Registriermarke darstellende Struktur kann auch aufgedruckt werden. Die Registriermarke kann vorher oder gleichzeitig mit der Strukturierung einer Kupferschicht auf einer oder beiden Seiten des Leiterplattenkerns erzeugt werden. Die Strukturierung der Kupferschicht(en) erfolgt durch mechanisches Bohren, Fräsen und Bearbeitung mit Laserlicht oder Ätzen. Durch das Entfernen von Kupfer werden Inseln geschaffen, die die elektrischen Verbindungen herstellen und gegeneinander elektrisch isoliert sind. Auf beiden Seiten des Leiterplattenkerns werden daraufhin Dielektrikumslagen aufgebracht. Anschließend können Microvias durch Laserbohren erzeugt werden, d.h. Löcher im Dielektrikum. Das Laserbohren wird an der Registriermarke im Zentrum der Leiterplatte ausgerichtet. In einem Metallisierungsprozess werden die Microvias mit elektrisch leitendem Material ausgekleidet. Daraufhin kann auf die Dielektrikumsschicht(en) jeweils eine Kupferschicht aufgebracht werden. Die Kupferschichten sind sehr dünne Lagen, die bereits vorher strukturiert wurden, und auf einer Trägerfolie aufgebracht sind. Die Kupferschichten weisen ebenfalls eine Registrierungsmarke im Zentrum auf, an der die Strukturierung ausgerichtet wurde. Wenn die Kupferschichten auf die Dielektrikumsschichten aufgebracht werden, werden sie an den Registrierungsmarken des Leiterplattenkerns ausgerichtet. Die Kupferschichten stehen über die Microvias elektrisch leitend mit dem Leiterplattenkern in Verbindung. Anschließend werden die Schichten miteinander verpresst. Damit die Registriermarke im Zentrum des Leiterplattenkerns zur Ausrichtung der einzelnen Lagen zueinander verwendet werden kann, wird sie entweder durch Röntgen lokalisiert oder durch Fräsen, Ätzen oder Laserbearbeitung frei gelegt und dann optisch erfasst. Ist als Registriermarke ein Loch vorgesehen, kann sie über einen Taststift erfasst werden. Die bislang genannten Verfahrensschritte können sich wiederholen, bis eine HDI Leiterplatte mit ca. 20 Lagen erreicht ist. Alternativ können mehrlagige Schichtenstapel bestehend aus einem Verbund von Kupferlagen und Dielektrikum, die analog zum Leiterplattenkern hergestellt werden, auf den Leiterplattenkern lose geschichtet werden und anschließend gemeinsam miteinander verpresst werden. Anschließend kann der Montagerahmen durch Fräsen entfernt werden und kann ein Test der Leiterplatte durchgeführt werden.

## Patentansprüche

1.  Verfahren zur Herstellung von mehrlagigen High Density Interconnect (HDI) Leiterplatten (1) bei dem Orientierungspunkte (3-6) für die einzelnen Lagen auf einem Montagerahmen (2) außerhalb der eigentlichen Leiterplatte (1) angeordnet werden, **dadurch gekennzeichnet, dass** ein weiterer Orientierungspunkt (10) als Ursprung für alle Lagen auf der eigentlichen Leiterplatte (1) angeordnet wird.

2.  Verfahren nach Anspruch 1, **dadurch gekennzeichnet, dass** der weitere Orientierungspunkt (10) im Zentrum der eigentlichen Leiterplatte (1) gewählt wird.

3.  Verfahren nach Anspruch 1 oder 2, **dadurch gekennzeichnet, dass** alle Herstellungsschritte an dem weiteren Orientierungspunkt (10) ausgerichtet werden.

4.  HDI Leiterplatte, **dadurch gekennzeichnet, dass** mindestens ein Orientierungspunkt (10) für die Ausrichtung der Lagen und/oder Strukturen während der Herstellung der Leiterplatte (1) auf der Leiterplatte (1) vorgesehen ist.

5.  HDI Leiterplatte nach Anspruch 4, **dadurch gekennzeichnet, dass** der Orientierungspunkt (10) im Zentrum der Leiterplatte (1) angeordnet ist.

6.  HDI Leiterplatte nach einem der Ansprüche 4 oder 5, **dadurch gekennzeichnet, dass** die HDI Leiterplatte (1) von einem Montagerahmen (2) umgeben ist, der weitere Orientierungspunkte (3-6) aufweist.

7.  Montagevorrichtung zur Herstellung einer HDI-Leiterplatte nach einem der Ansprüche 4 bis 6 unter Durchführung des Verfahrens nach einem der Ansprüche 1 bis 3.

# Fig. 1

# Fig. 2

**Europäisches Patentamt**

**EUROPÄISCHER RECHERCHENBERICHT**

Nummer der Anmeldung

EP 01 44 0200

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | US 6 165 658 A (TAFF ET AL.) 26. Dezember 2000 (2000-12-26) * Zusammenfassung; Abbildung 1 * | 1,4 | H05K3/46 H05K3/00 |
| A | MICHAEL ANGELO: "POSTPROCESSING: MULTILAYER REGISTRATION FOR THE 1990S" PRINTED CIRCUIT FABRICATION, MILLER FREEMAN INC, SAN FRANCISCO, US, Bd. 15, Nr. 4, 1. April 1992 (1992-04-01), Seiten 24-27, XP000271238 * das ganze Dokument * | 1 | |
| A | US 5 377 404 A (BERG) 3. Januar 1995 (1995-01-03) * das ganze Dokument * | 1 | |
| A | PATENT ABSTRACTS OF JAPAN vol. 1997, no. 05, 30. Mai 1997 (1997-05-30) & JP 09 018155 A (MATSUSHITA ELECTRIC WORKS LTD), 17. Januar 1997 (1997-01-17) * Zusammenfassung * | 1 | |

**RECHERCHIERTE SACHGEBIETE (Int.Cl.7)**

H05K

Der vorliegende Recherchenbericht wurde für alle Patentansprüche erstellt

| Recherchenort | Abschlußdatum der Recherche | Prüfer |
|---|---|---|
| DEN HAAG | 9. November 2001 | Mes, L |

**ANHANG ZUM EUROPÄISCHEN RECHERCHENBERICHT
ÜBER DIE EUROPÄISCHE PATENTANMELDUNG NR.**                    EP 01 44 0200

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

09-11-2001

| Im Recherchenbericht angeführtes Patentdokument | Datum der Veröffentlichung | Mitglied(er) der Patentfamilie | Datum der Veröffentlichung |
|---|---|---|---|
| US 6165658      A | 26-12-2000 | KEINE | |
| US 5377404      A | 03-01-1995 | WO      9408443 A1 | 14-04-1994 |
| JP 09018155      A | 17-01-1997 | KEINE | |

EPO FORM P0461

Für nähere Einzelheiten zu diesem Anhang : siehe Amtsblatt des Europäischen Patentamts, Nr.12/82